# EUROPEAN PATENT APPLICATION

(11) **EP 4 711 778 A2**
(43) Date of publication of application: **18.03.2026**
(21) Application number: 25196911.9
(22) Date of filing: 20.08.2025
(51) Int. Cl.: G01R 31/08, G01R 31/52

(54) **SYSTEMS AND METHODS FOR MONITORING AN ELECTRICAL DISTRIBUTION SYSTEM**

(30) Priority: 21.08.2024 US 202463685565 P
(71) Applicant: Eaton Intelligent Power Limited, Dublin 4, D04 Y0C2 (IE)
(72) Inventor: Singh, Gurmeet, Pune (IN); Patnaik, Bibhudatta, Bhubaneswar (IN); Sonawane, Abhishek Dilip, Pune (IN); Agarwal, Archit, Greenwood (US); Lawlor, Walter James, Hodges (US); Balasubramanian, Pranavamoorthy, Pune (IN)
(74) Representative: Epping - Hermann - Fischer

(57) **Abstract**

An electrical conductor monitoring system for single or multi-phase conductors is described. The monitoring system may be configured to monitor the health of a conduction system based on multi-phase sequences and/or current magnitude and angle vectors of multiphase or single-phase current. In one example, the monitoring system includes an insulation health monitoring system having an input and output measurement devices, the input measurement device disposed at an input end of the electrical distribution system and structured to measure three-phase input currents, the output measurement device disposed at an output end of the electrical distribution system and structured to measure three-phase output currents; and a monitoring device communicatively coupled to the measurement devices and structured to receive the three-phase input and output currents from the measurement devices and determine a state of the insulation system based on the three-phase input and output currents. Other embodiments are described.

## Description

### CROSS REFERENCE TO RELATED APPLICATIONS

This application claims priority to U.S. Provisional Patent Application Serial No. 63/685,565, filed on August 21, 2024 and titled "ELECTRICAL INSULATION MONITORING SYSTEM AND METHOD," the disclosure of which is incorporated herein by reference.

### TECHNOLOGICAL FIELD

The present disclosure is directed to monitoring an electrical distribution system, such as an electrical busway system, including determining leakage current and/or detecting faults and fault severity, and, in particular, to monitoring an electrical distribution system via in-line analysis of electrical parameters between a set of points along sections of the electrical distribution system.

### BACKGROUND

High-power and high-demand electrical distribution systems typically use conductors arranged in pre-fabricated conduit to distribute electrical energy from a power source to electrical equipment, such as switchgear, panelboards, transformers, and computing devices. The conduit provides the mechanical support and facilitates the organization required for the extended conductor length and numerous link segments. The conductors may include power cables or wires arranged within cable trays and/or bus bars arranged within busway or busduct to form an electrical busway. Such electrical distribution systems are common in data centers, but are also prevalent in laboratories, warehouses, and manufacturing facilities, among other applications.

While cable trays and busways have emerged as a popular electrical power distribution system due to their ease of installation, configuration, and reconfiguration, such electrical distribution systems face substantive challenges, including contact failure and insulation failure.

All insulators have a base level of leakage current. An insulation failure occurs when the leakage current is greater than the base level. Such failures may occur as a result of an increased current leaking to ground and/or from one conductor to another due to degradation or other damage to the insulation. For example, insulation leakage current may increase (e.g., without limitation, due to water or other environment factors) in faulty sections of the conduit over time, eventually leading to a system failure. Such system failures result in unexpected and costly downtimes and/or equipment damage.

As a result, standards require bus bars and other conductors to pass contactor and insulation resistance tests on each busway for a predefined period (e.g., without limitation, one minute). Existing approaches for testing or measuring insulation resistances require the subject conductor section to be powered off (or disconnected from the main system) during the testing or measurement. Such off-line measurements result in production losses, and, thus, are performed infrequently during scheduled maintenance (for instance, on a bi-annual or annual basis). Accordingly, a leakage current increase will go undetected in a faulty section between testing events, thereby resulting in an acceleration of the severity of the fault.

As a result of the foregoing, faults within high-power electrical distribution systems are not detected until a breaker, switch, fuse, or other protective element is tripped and a section of the electrical distribution system is taken off-line and, in many cases, damaged. Accordingly, electrical distribution systems would benefit from techniques for detecting and analyzing fault conditions within connected and active sections.

### SUMMARY

This Summary is provided to introduce a selection of concepts in a simplified form that are further described below in the Detailed Description. This Summary is not intended to identify key features or essential features of the claimed subject matter, nor is it intended as an aid in determining the scope of the claimed subject matter.

The present disclosure describes various embodiments of a fault detection system for an electrical distribution system.

In one example, an electrical distribution system may include a conduction system formed of at least one segment of multi-phase conductors configured to carry current between a current source and a current load, a measurement system operatively coupled to the multi-phase conductors to measure current information of the multi-phase conductors, the measurement system comprising at least one upstream sensor and at least one downstream sensor arranged at opposite ends of a measurement section of the multi-phase conductors; and a conduction system monitoring device communicatively coupled to the sensor system, the conduction system monitoring device operative to: determine sequence components based on the current information received from the sensor system, determine a sequence component difference based on a comparison of the upstream sequence components at an upstream point of the measurement section with downstream sequence components at a downstream point of the measurement section, the sequence component difference associated with a leakage current of at least one of the multi-phase conductors, and determine a status of the conduction system based on the sequence component difference.

In some embodiments of the electrical distribution system, the multi-phase conductors comprise three-phase conductors.

In various embodiments of the electrical distribution system, the conduction system monitoring device is further operative to determine the sequence component difference as a zero sequence component difference based on a difference between an upstream zero sequence component and a downstream zero sequence component. In some embodiments of the electrical distribution system, the conduction system monitoring device is further operative to determine a phase-to-phase fault responsive to the zero sequence component difference being greater than a zero sequence threshold.

In various embodiments of the electrical distribution system, the conduction system monitoring device is further operative to determine the sequence component difference as a negative sequence component difference based on a difference between an upstream negative sequence component and a downstream negative sequence component. In some embodiments of the electrical distribution system, the conduction system monitoring device is further operative to determine a phase-to-ground fault responsive to the negative sequence component difference being greater than a negative sequence threshold.

In exemplary embodiments of the electrical distribution system, the status comprises a status of an insulation system configured to provide insulation between the multi-phase conductors and between the multi-phase conductors and ground.

In some embodiments of the electrical distribution system, the conduction system monitoring device configured to determine a progression of an increase in the sequence component difference. In various embodiments of the electrical distribution system, the conduction system monitoring device configured to determine whether a fault due to the sequence component difference being over a threshold is due to a degradation of the insulation system.

In some embodiments of the electrical distribution system, the conduction system monitoring device further operative to: determine a fault status of each phase of the multi-phase conductors, and determine phases of a phase-to-phase fault based on the sequence component difference of each phase of the multi-phase conductors.

In one example, an electrical insulation health monitoring system for use in an electrical power distribution system having three-phase conductors and an insulation system may include a measurement device including an input measurement device and an output measurement device, the input measurement device disposed at an input end of the electrical power distribution system and configured to measure three-phase input current at the input end, the output measurement device disposed at an output end of the electrical power distribution system and structured to measure three-phase output current at the output end; and an insulation health monitoring device communicatively coupled to the input measurement device and the output measurement device and configured to receive the three-phase input current and the three-phase output current to determine an instantaneous state of the insulation system based on the measured three-phase input current and the three-phase output current.

In some embodiments of the electrical insulation health monitoring system, the insulation health monitoring device is configured to determine the instantaneous state of the insulation system by: deriving sequence components from the measured three-phase input current and the three-phase output current, obtaining sequence component differences between input current sequence components of the three-phase input current and output current sequence components of the three-phase output current, and determining the instantaneous state of the insulation system based on the sequence component differences.

In various embodiments of the electrical insulation health monitoring system, the insulation health monitoring device is further configured to determine: that the insulation system is in a healthy state based on a determination that the sequence component differences are less than respective tolerances, or that the insulation system includes a fault based on a determination that one or more differences in the sequence components are greater than respective tolerances.

In some embodiments of the electrical insulation health monitoring system, the sequence components comprise zero sequence components and negative sequence components, the differences include a first difference between zero sequence components of the three-phase input current and the three-phase output current and a second difference between negative sequence components of the three-phase input current and the three-phase output current, and the insulation health monitoring device is further configured to determine a type and a severity of a detected fault based on a threshold, the type including a phase-to-ground fault based on a determination that the first difference is greater than a first threshold and a phase-to-phase fault based on a determination that the second difference is greater than a second threshold.

In exemplary embodiments of the electrical insulation health monitoring system, the insulation health monitoring device is further configured to determine a degradation pattern based on the instantaneous state of the insulation system wherein the degradation pattern comprises a natural degradation pattern for which warranty service is applied and an unnatural degradation pattern requiring an investigation.

In one example, a method for monitoring insulation health of an insulation system of an electrical distribution system may include providing a measurement system operatively coupled to at least one conductor of a conduction system of the electrical distribution system to measure current information of current flowing from a source to a load through the at least one conductor, the measurement system comprising at least one source side sensor and at least one load side sensor arranged at opposite ends of a measurement section of the at least one conductor; and performing, via an insulation health monitoring system: collecting current information of source side current of the at least one source side sensor and load side current of the at least one load side sensor, determining a source side current vector (IS) and a load side current vector (IL) based on the current information, determining a fault current (I_{f}) based on a difference between IS and IR, and estimating an insulation resistance (Rᵢ) based on I_{f},

In some embodiments of the method, the method further includes, via the insulation health monitoring system, determining a remaining useful life (RUL) of at least one component of the insulation system based on Rᵢ. In various embodiments of the method, the method further includes, via the insulation health monitoring system, determining Rᵢ based on Rᵢ = V/I_{f}, wherein V is a supply voltage value. In some embodiments of the method, the source side current vector (IS) comprises a magnitude (I1) and an angle (Ø1) of the source side current and the load side current vector (IS) comprises a magnitude (I2) and an angle (Ø2) of the load side current.

In exemplary embodiments of the method, the method further includes, via the insulation health monitoring system, applying a filter to use current information of a supply frequency of interest.

The disadvantages and shortcomings of existing systems may be met by an electrical insulation health monitoring system for use in an electrical power distribution system having three-phase conductors and an insulation system. The electrical insulation health monitoring system includes: a measurement device including an input measurement device and an output measurement device, the input measurement device disposed at an input end of the electrical power distribution system and structured to measure three-phase input currents, the output measurement device disposed at an output end of the electrical power distribution system and structured to measure three-phase output currents; and an insulation health monitoring device communicatively coupled to the measurement device and structured to receive the measured three-phase input and output currents from the measurement device and determine instantaneous state of the insulation system based on the measured three-phase input and output currents.

Another example embodiment includes a method for monitoring insulation health of an electrical power distribution system having three-phase conductors and an insulation system. The method includes: measuring three-phase input currents at an input end of the electrical power distribution system and three-phase output currents at an output end of the electrical power distribution system; receiving the measured three-phase input and output currents; and determining instantaneous state of the insulation system based on the measured three-phase input and output currents.

### BRIEF DESCRIPTION OF THE DRAWINGS:

By way of example, features of the disclosed embodiments are described with reference to the accompanying drawings, in which:
FIGS. 1A-1C depict an illustrative example of an electrical distribution system in accordance with the present disclosure;
FIGS. 2A and 2B depict an illustrative example of an electrical conductor monitoring system in accordance with the present disclosure;
FIG. 3 depicts an illustrative example of an electrical conductor monitoring system in accordance with the present disclosure;
FIG. 4 depicts graphs of monitoring information of a healthy conductor section in accordance with the present disclosure;
FIG. 5 depicts graphs of monitoring information of a faulted conductor section in accordance with the present disclosure;
FIG. 6 depicts an illustrative example of a workflow of an electrical conductor monitoring system in accordance with the present disclosure;
FIG. 7 depicts graphs of fault indication information of an electrical conductor monitoring system in accordance with the present disclosure;
FIG. 8 depicts an illustrative example of an electrical conductor monitoring system in accordance with the present disclosure;
FIG. 9 depicts an illustrative example of a phase shift of currents in vector form; FIG. 10 depicts graphs of monitoring information of a magnitude (D) in accordance with the present disclosure;
FIG. 11 depicts graphs of monitoring information of a phase difference (Ø) in accordance with the present disclosure;
FIG. 12 depicts a graph of monitoring information of insulation resistance (Rᵢ) over time in accordance with the present disclosure; and
FIG. 13 depicts a graph of monitoring information of a fault indicator in accordance with the present disclosure.

### DETAILED DESCRIPTION

Various features of an electrical conductor monitoring system are described in the present disclosure, with reference to the accompanying drawings, in which one or more features of the electrical conductor monitoring system are shown and described. The various features described in the present disclosure and depicted in the accompanying drawings may be used independently of or in combination with each other. An electrical conductor monitoring system as disclosed herein may be embodied in many different forms and should not be construed as being limited to the examples set forth herein. Rather, these examples are provided to convey certain features of the electrical conductor monitoring system to those skilled in the art.

An electrical conductor monitoring system according to some embodiments may include a pair of in-line sensors configured to measure parameters of electricity distribution between two points along a section of a conductor of an electrical distribution system. In some embodiments, the sensors may detect the parameter of current and/or voltage. The electrical conductor monitoring system may analyze the measured parameters and/or information determined based on the measured parameters at the two points to determine whether a fault condition exists within the monitored section of the conductor. In some embodiments, the fault condition may include element degradation, for instance, indicated by the gradual increase in the leakage of current over a base line current leakage. In various embodiments, the fault condition may include a failure indicated by a spike in an amount of current leakage. In some embodiments, the fault condition may include the presence of a leakage current, for instance, over a tolerance level, threshold/ or baseline leakage current.

In various embodiments, the electrical conductor monitoring system may be configured to monitor the status of one or more elements of the electrical distribution system. For example, in some embodiments, the electrical conductor monitoring system may be or may operate, at least partially, as an electrical insulation monitoring system configured to monitor the status of insulation of a section of the conductor based on a determined leakage current.

Directional phrases used herein, such as, for example, left, right, front, back, top, bottom, upwards, downwards, variations thereof, and derivatives thereof relate to the orientation of the elements shown in the drawings and are not limiting upon the claims unless expressly recited therein.

As used herein, employed herein, when ordinal terms such as "first" and "second" are used to modify a noun, such use is simply intended to distinguish one item from another, and is not intended to require a sequential order unless specifically stated.

As employed herein, the statement that two or more parts or components are "coupled" means that the parts are joined or operate together either directly or indirectly, for instance, indirectly through one or more intermediate parts or components, so long as a link occurs. As used herein, "fixedly coupled" or "fixed" means that two components are coupled so as to move as one while maintaining a constant orientation relative to each other.

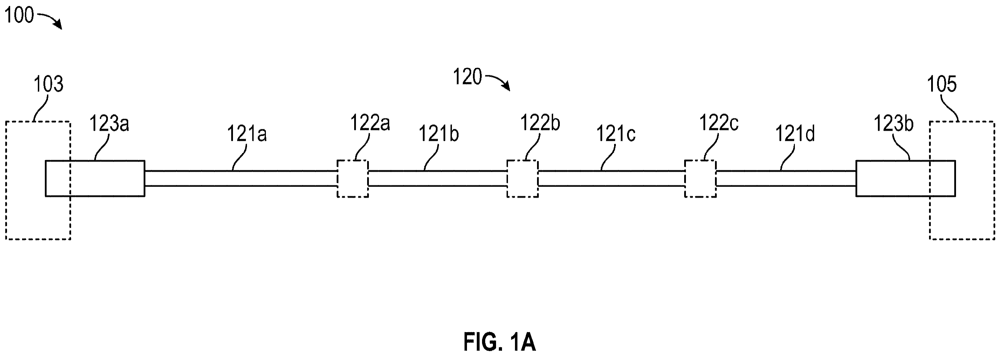

FIGS. 1A-1C depict an illustrative example of an electrical distribution system in accordance with the present disclosure. As shown in FIGS. 1A-1C, an electrical distribution system (or electrical power system) 100 may include a conduction system 120 configured to electrically connect one or more power sources 103 to one or more loads 105. The conduction system 120 may include a conduit 110 having a conductor 112 arranged therein that carries electrical current from the source 103 to a load 105.

In various embodiments, the conduction system 120 may be formed of multiple segments or sections 121a-d. The sections 121a-d may be coupled via connectors 122a-c configured to connect the conductors 112 of one segment 121a-d to the conductors 112 of another segment. In other embodiments, the conduction system 120 may be formed of a single, continuous section 121 (for instance, without connectors 122a-c).

The electrical distribution system 100 may be any appropriate electrical power distribution system including, without limitation, a busway system, a busduct, cable trays or conduits, termination blocks, etc. Further, the electrical distribution system 100 may include any type of conductor, including, without limitation, cables, bus bars, wires, etc. In various embodiments, the electrical distribution system 100 may be a multi-phase, such as a three-phase, two-phase, or five-phase system. In some embodiments, the electrical distribution system 100 may be a single phase system. In various embodiments, the electrical distribution system 100 may be a three-phase system. In some embodiments, the electrical distribution system 100 may be configured for AC current. In various embodiments, the electrical distribution system 100 may be configured for DC current.

In some embodiments, the electrical distribution system 100 and/or components thereof may be configured the same or substantially similar to the PowerWave or Pow-R-Way busway system provided by Eaton Corporation PLC of Dublin, Ireland.

Although a three-phase circuit for a busway system is used in some examples of an electrical distribution system 100, embodiments are not so limited, as the electrical distribution system 100 may be or may include other phase systems and/or conductors.

Referring to FIG. 1A, the electrical distribution system 100 is depicted as a busway system 120. The busway system 120 includes a plurality of segments in the form of busway (or busway "rails") 121a-d connected in series. The busway system is connected to the power source 103 at an input (line side) end 123a and the loads 105 at an output (load side) end 123b.

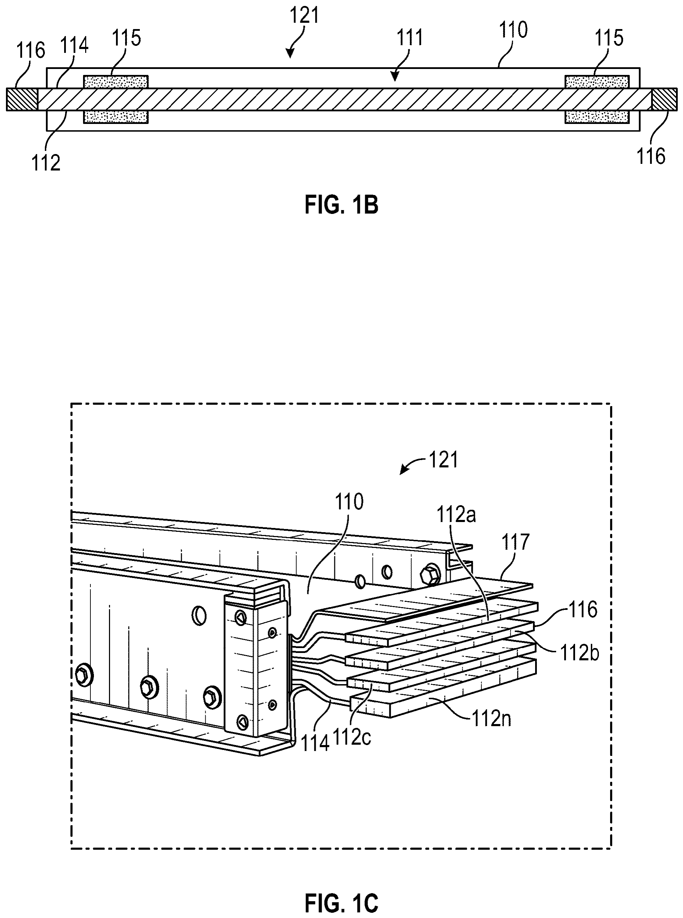

Referring to FIGS. 1B and 1C, each busway 121 includes bus bars 112 arranged longitudinally within the body or conduit 110 of the rail 121. In the non-limiting example of FIG. 1C, the busway 121 is configured as a three-phase "sandwich" type of busway rail with a threephase 4-wire system having an A conductor 112a, a B conductor 112b, a C conductor 112c, the optional neutral or N conductor 112n, and a ground 117 element.

A conductor of the electrical distribution system 100, including the conductor 112, may include insulation and non-insulated ends for forming electrical connections. Referring to FIGS. 1B and 1C, the conductor 112 is coated in insulation 114. For example, a bus bar may be coated in an epoxy (such as an epoxy powder), vinyl, and/or other insulating materials. In some embodiments, other insulating elements 115 may be included, instead of or in addition to the coating insulation 114, such as insulating blocks or other structures arranged around the conductors 112. The insulation 114 and/or 115 operates to reduce, minimize, eliminate, or prevent current leakage between the conductors 112 and/or between the conductors 112 and ground. The insulation 114 and/or the insulating elements 115 may constitute an insulation system for the system 120.

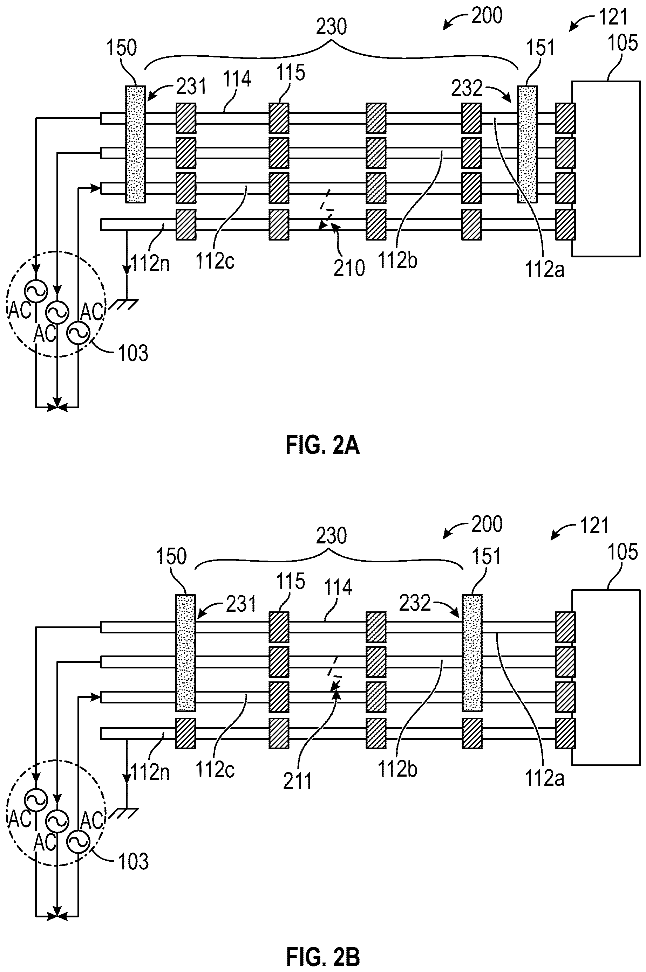

FIGS. 2A and 2B depict an illustrative example of an electrical conductor monitoring system in accordance with the present disclosure. More specifically, FIGS. 2A and 2B depict a block diagram of an internal view of a conduction segment 121 for an electrical conductor monitoring system 200. In the non-limiting example of FIGS. 2A and 2B, the conduction segment 121 is a busway rail of a three-phase busway system. For example, the conductors 112an may be or may include an R phase conductor 112a, a Y phase conductor 112b, a B phase conductor 112c, and a ground conductor 112n.

As shown in FIGS. 2A and 2B, one or more sensors 150, 151 may be electrically coupled to one or more of the conductors 112a-d. The sensors 150, 151 may be configured to measure one or more parameters associated with the flow of current through the conductors 112a-d. Nonlimiting examples of the parameters may include current, voltage, and/or the like. In some embodiments, the sensors 150, 151 may include a pair of sensors configured to measure parameter values at two different points 231, 232 along a measurement section 230 of the conductors 112a-n. A first, upstream, M1, or input sensor 150 may be configured to measure the electrical parameters at an input end or upstream position of the conductor(s) 121, and a second, downstream, M2, or output sensor 151 may be configured to measure the electrical parameters at an output end or downstream position of the conductor(s) 121. For example, with respect to the flow of current from a source 103 to a load 105, the M1 sensor 150 is upstream of the M2 sensor 151.

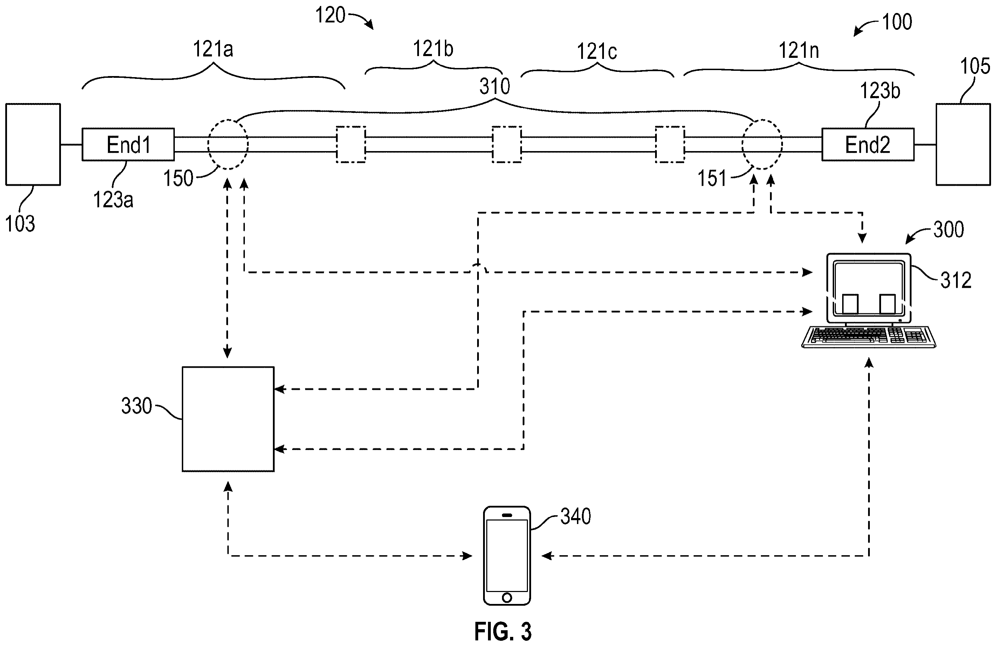

Although the sensors 150, 151 are depicted as being arranged within a single busway section 121, embodiments are not so limited, as the sensors 150, 151 may be arranged in different sections (see, for example, FIG. 3). For example, the sensor 150 may be arranged in a first section 121a and the sensor 151 may be arranged in a second section 121n, with the first section 121a being upstream from the second section 121n with respect to the flow of current from the source 103 to the load 105. Although only one source or upstream sensor 150 and one load or downstream sensor 151 are depicted, embodiments are not so limited. For example, the upstream sensor 150 may be or may include a plurality of sensors (for instance, with one sensor for each conductor 112a-n) and the downstream sensor 151 may be or may include a plurality of sensors (for instance, with one sensor for each conductor 112a-n).

As described in more detail in the present disclosure, the parameter values measured by the sensors 150, 151 (and/or electrical properties determined based on the measured parameter values) may be analyzed (for instance, compared) to evaluate any leakage current occurring within one or more of the conductors 112a-n as the current travels from the source 103 to a load 105. In some embodiments, the electrical properties determined based on the measured parameter values may be or may include the sequence values for a multi-phase system, such as the negative sequence values, zero sequence values, and/or the positive sequence values. For example, the electrical conductor monitoring system 200 may operate to determine a ground current leakage 210 between a phase 112c and a ground 112n as shown in FIG. 2A and an interphase current leakage 211 between phases (for instance, the Y phase 112b and the B phase 112c) as shown in FIG. 2B.

FIG. 3 depicts an illustrative example of an electrical conductor monitoring system in accordance with the present disclosure. As shown in FIG. 3, an electrical conductor monitoring system 300 may include a measurement system 310 and a conduction system monitoring device 312. The measurement system 310 may include a plurality of sensors, such as sensors 150 and 151 configured to measure one or more electrical parameters. In some embodiments, the sensors 150 and 151 may be current sensors (e.g., without limitation, current transformers), power meters, or any other appropriate measurement devices. In the non-limiting example of FIG. 3, the input sensor 150 is disposed at the input end 123a of the busway system 120 and is structured to continuously measure the input current of each phase of the three phases and transmit the measured three-phase input currents to the monitoring device 312 in a wired or wireless connection. The output sensor 151 is disposed at the output end 123b of the busway system 120 and is structured to continuously measure the output current of each phase of the three phases and transmit the measured three-phase output currents to the monitoring device 312 in a wired or wireless connection.

In some embodiments, the busways 121a-n may be connected in series without any junction, and thus the values of each phase current remains the same (or essentially the same or lowered by an expected or baseline leakage current) when measured by the input sensor 150 at the input end 123a and the output sensor 151 at the output end 123b for a healthy system (e.g., a system without a short circuit or with a leakage current at or below a tolerance, threshold, or baseline amount).

In the embodiment depicted in FIG. 3, the monitoring device 312 is structured to receive the measured three-phase input and output currents from the input and output sensors 150, 151 and determine the instantaneous state of the system 120 based on the measured three-phase input and output currents. The monitoring device 312 may be, e.g., a processing unit included in, e.g., without limitation, a server, a personal computer, a portable computing device, a workstation, a main breaker in a load panel 330, and/or the like. The processing unit may include a processor and memory. The processor may be, for example and without limitation, a microprocessor, a microcontroller, or some other suitable processing device or circuitry. The memory can be any of one or more of a variety of types of internal and/or external storage media such as, without limitation, RAM, ROM, EPROM(s), EEPROM(s), FLASH, and the like that provide a storage register, for instance, a machine readable medium, for data storage including, without limitation, an internal storage area of a computer, and can be volatile memory or nonvolatile memory. The memory may store a software or firmware application for monitoring the status of the system 120 and/or components thereof, such as the insulation, as indicated by the determined leakage current.

Upon receiving the measured input and output phase currents, the monitoring device 312 extracts or derives sequence components including positive sequence components, negative sequence components, and/or zero sequence components from the measured three-phase input and output currents. In some embodiments, the monitoring device 312 may compare the input sequence components and the respective output sequence components. For example, the monitoring device 312 obtains a difference between the positive sequence component of the output phase currents and the positive sequence component of the input phase currents by subtracting the positive sequence component of the output phase currents from the positive sequence component of the input phase currents. In various embodiments, the monitoring device 312 may determine a first or zero sequence difference between the zero sequence component of the output phase currents and the zero sequence component of the input phase currents by subtracting the zero sequence component of the output phase currents from the zero sequence component of the input phase currents. In some embodiments, the monitoring device 312 may determine a second or negative sequence difference between the negative sequence component of the output phase currents and the negative sequence component of the input phase currents by subtracting the negative sequence component of the output phase currents from the negative sequence component of the input phase currents.

In various embodiments, based on the sequence component differences, predefined baseline values (tolerances), and predefined thresholds, the monitoring device 312 may operate to determine the instantaneous state of the system 120 and/or components thereof (e.g., the insulating system). The sequence component differences may include a first or zero difference associated with the zero sequence components and a second or negative difference associated with the negative sequence components. The predefined tolerances may include a first or zero sequence tolerance associated with the zero sequence components and a second or negative sequence tolerance associated with the negative sequence components. The predefined thresholds may include a first or zero sequence threshold associated with the zero sequence components and a second or negative sequence threshold associated with the negative sequence components. The tolerance values and the threshold values may be set or determined depending on one or more threshold factors, including, without limitation, the type of the sensors 150, 151, the length of the busway system 120, the length of the measurement section 230, the voltage rating, the current rating, and/or other factors. For example, the first tolerance may be, e.g., without limitation, 10% of the three-phase input current, and the predefined first threshold may be, e.g., without limitation, 20% of the three-phase input current.

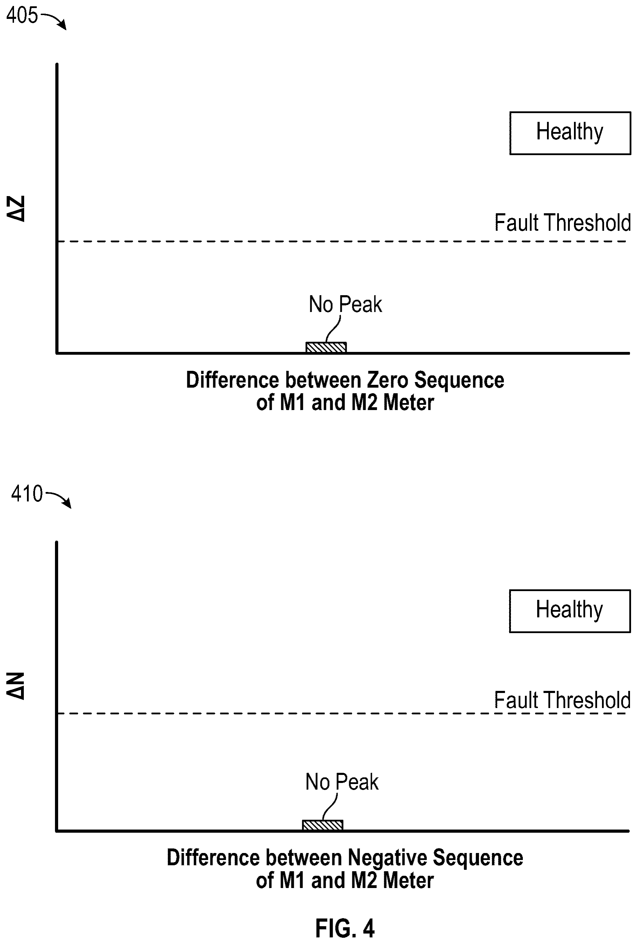

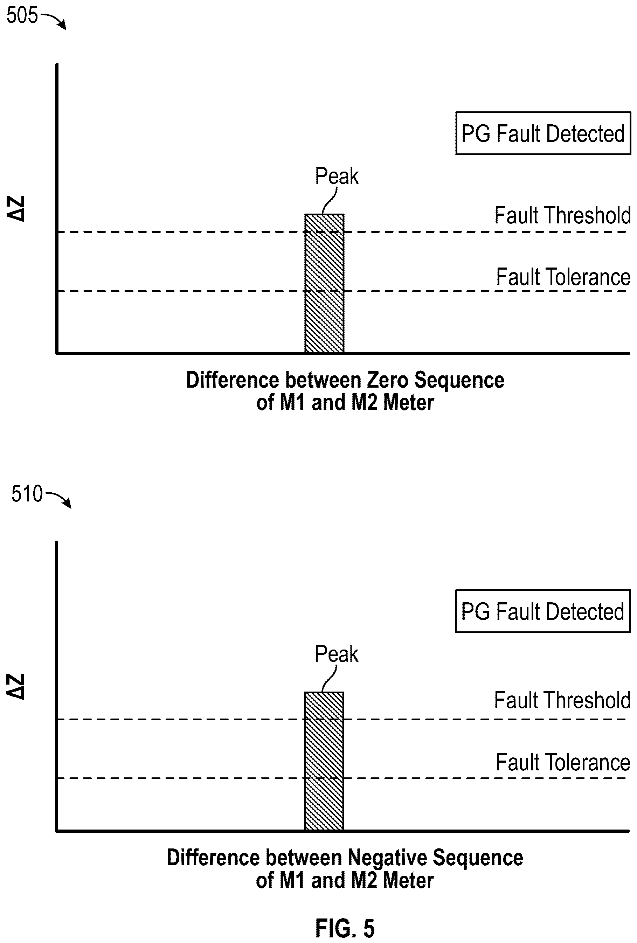

The monitoring device 312 may operate to determine that the system 120 (and/or components thereof) is in a healthy or faulted state based on whether the first difference and/or the second difference are less than or greater than the respective tolerances. FIG. 4 depicts graphs of monitoring information of a healthy conductor section in accordance with the present disclosure and FIG. 5 depicts graphs of monitoring information of a faulted conductor section in accordance with the present disclosure.

For example, referring to FIG. 4, graph 405 shows that there is no peak in the first difference between the zero sequences of the measured three-phase input and output currents (ΔZ below fault threshold), and graph 410 shows that there is no peak in the second difference between the negative sequences of the measure three-phase input and output currents (ΔN below fault threshold). In another example, referring to FIG. 5, graph 505 shows that the busway system 120 includes a phase-to-ground fault (e.g., a short circuit 210 between a phase and a ground as shown in FIG. 2A) based on a peak detected (ΔZ above fault threshold) in the first difference between the zero sequences of the measured three-phase input and output currents, and graph 510 shows that the busway system 120 includes a phase-to-phase fault (e.g., a short circuit 211 between the Y phase and the B phase as shown in FIG. 2B) based on a peak (ΔN above fault threshold) detected in the second difference between the negative sequences of the measured three-phase input and output currents.

The monitoring device 312 may be further structured to determine the severity of the detected fault. For example, the monitoring device 312 may determine that the phase-to-ground fault has low severity based on the fact that the first difference is greater than a first tolerance but less than the first threshold. In such low severity phase-to-ground fault scenario, the busway system 120 may continue to operate. The monitoring device 312 may determine that the phaseto-ground fault has high severity based on a determination that the first difference is greater than the first threshold. Such high severity phase-to-ground fault scenario may require an immediate shutdown of the busway system 120. The monitoring device 312 may determine that the phaseto-phase fault has low severity based on the second difference being greater than the second tolerance but less than the second threshold. In such low severity phase-to-phased fault scenario, the busway system 120 may continue to operate and remain operational. The monitoring device 312 may determine that the phase-to-phase fault has high severity based on a determination that the second difference is greater than the second threshold, requiring an immediate shutdown of the busway system 120.

In some embodiments, upon detecting a fault and the type of the fault (e.g., low severity - above tolerance/below threshold or high severity - above threshold), the monitoring device 312 may be further structured to detect a power loss in the insulation system and identify one or more faulty phases of the insulation system. That is, the sensors 150, 151 may measure input and output power at respective ends 123a, 123b (or over the span of the measurement section 230) for each phase (for example, without limitation, A, B, C phases or R, Y, B phases), detects a power loss, and identifies a faulty phase based on the detected power loss.

For example, in some embodiments, the input sensor 150 may measure input power for each phase A, B and C at the input end 123a (or the upstream point 231 of the measurement section 230), and the output sensor 151 may measure output power for each phase A, B and C at the output end 123b (or the downstream point 232 of the measurement section 230). The monitoring device 312 then obtains the differences between the input power (or sequence components) and the output power (or sequence components) for each phase by subtracting phase output power (or sequence components) from the respective phase input power (or sequence components).

If a difference in the output power (or sequence components) and the input power (or sequence components) is less than a baseline power loss (power loss tolerance), then the monitoring device 312 determines that the corresponding phase is healthy. If a difference is greater than the power loss tolerance, then the monitoring device 312 determines that the corresponding phase is faulty. The power loss tolerance may vary depending on, for example and without limitation, a type of the measurement device, a length of the insulation system 24, a length of the measurement section 230, the current rating, the amperage rating, and/or the like.

Table 1 provides illustrative faulty phase identifications:

**Table 1**

| **PLossA** | **PLossB** | **PLossC** | **Status** |
|---|---|---|---|
| 0 | 0 | 0 | Healthy |
| 1 | 0 | 0 | PG-A phase faulty |
| 0 | 1 | 0 | PG-B phase faulty |
| 0 | 0 | 1 | PG-C phase faulty |
| 1 | 1 | 0 | PP-AB phase faulty |
| 1 | 0 | 1 | PP-AC phase faulty |
| 0 | 1 | 1 | PP-BC phase faulty |
| 1 | 1 | 1 | PP-ABC phase faulty |

In Table 1, power loss for each phase (PLossA, PLossB, PLossC) is determined by assigning value "0" for a healthy state and value "1" for a faulty state. By determining the power loss at each phase, the monitoring device 312 can detect multiple fault scenarios (e.g., without limitation, all phase faults).

In addition, the monitoring device 312 may also include an indication device. The indication device may be, e.g., without limitation, a set of LEDs, a graphical display, and/or audible components and structured to indicate the instantaneous state of the insulation system including an alert to the user of detected fault(s) and the severity of the fault(s). In some embodiments, the monitoring device 312 may include a display to present warning messages, fault status, system status, and/or the like. In various embodiments, the monitoring device 312 may be configured to transmit messages over a network to operator computing devices indicating warning messages, fault status, system status, and/or the like.

For example, if the system 120 (or components thereof, such as the insulation system) is determined to be healthy, no alert is generated and the indication device indicates the healthy state by lighting or displaying, e.g., without limitation, a green LED. If the system 120 (or components thereof, such as the insulation system) is determined to include a low severity fault, the indication device generates a moderate alert indicative of the low severity, the type of the fault, and any recommended remedial actions. If the system 120 (or components thereof, such as the insulation system) is determined to include a high severity fault, the indication device may generate a severe alert indicative of the high severity, the type of the fault and remedial actions to be performed immediately. Further, the indication device may indicate the identification of one or more faulty phases by, for example, displaying or transmitting a message to the user. In some embodiments, in the case of a serve fault, the monitoring device may shut down, isolate, or otherwise prevent the flow of electricity through the affected conductor sections.

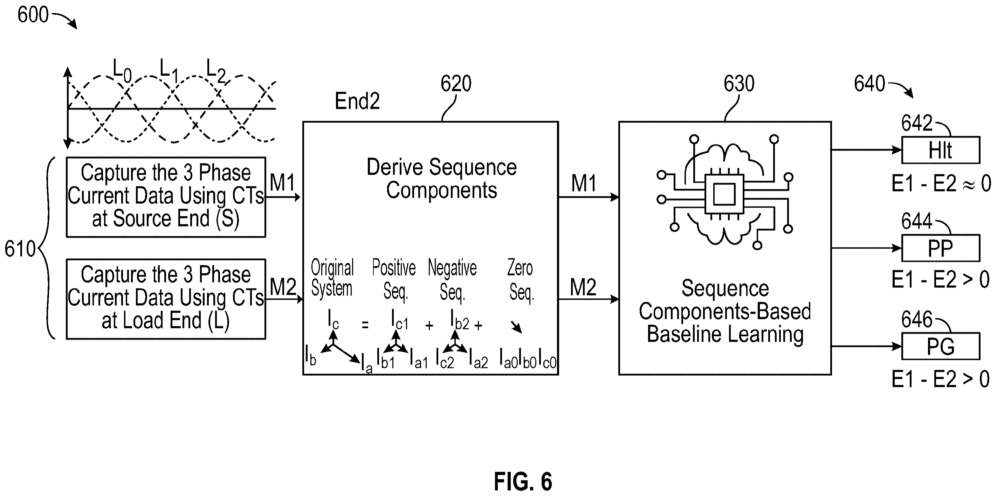

FIG. 6 depicts an illustrative example of a monitoring method of an electrical conductor monitoring system in accordance with the present disclosure. More specifically, FIG. 6 illustrates a monitoring method 600 of real-time monitoring of the state of an electrical conduction system in an electrical distribution system. The method 600 may be performed by one of the monitoring systems 200 or 300 and/or any component thereof.

At step 610, an input measurement device (M1 or upstream sensor) measures three-phase input currents at an input end (or upstream point) of a busway system (or measurement section of a busway system) and an output measurement device (M2 or downstream sensor) measures three-phase output currents at an output end (or downstream point) of the busway system (or measurement section of a busway system). The measurement devices then transmit the measured input and output three-phase current data to a monitoring device.

At step 620, the monitoring device derives sequence components of the measured threephase input and output currents, including, for example, a zero sequence component, a positive sequence component, and/or a negative sequence component. In some examples, the output measurement device (or downstream sensor) may determine the sequence components and transmit three-phase current data including the sequence components to the monitoring device.

At step 630, the monitoring device compares the sequence components of the measured three-phase input and output currents by obtaining the differences between the output component sequences and the respective input component sequences.

At step 640, the monitoring device determines the instantaneous state of the busway system (or measurement section of the busway system) based on the differences and predefined tolerances and thresholds. If the differences are within the tolerances, at step 642 the insulation device determines that the insulation system is healthy. If the difference between the negative sequence components of the measured three-phase input and output currents is greater than the second tolerance, at step 644 the monitoring device determines that the busway system includes a phase-to-phase fault. If the difference between the zero sequence components of the measured three-phase input and output currents is greater than the first tolerance, at step 646 the monitoring device determines that the busway system includes a phase-to-ground fault. The monitoring device then further determines the severity of the detected fault and transmits an alert to an operator based on the severity of the detected fault (e.g., above tolerance, but below threshold; above threshold; etc.).

Accordingly, the monitoring system 300 and the method 600 allow real-time monitoring of the instantaneous state of the busway system (and/or components thereof, such as the insulation system) without having to shut down the system 120 as required by the existing insulation fault measurement systems, thereby eliminating the production losses and profit losses that result when using the existing electrical insulation fault measurement systems. Further, by providing an alert in accordance with the severity of a detected fault, the monitoring system 300 and the method 600 enable operators to take appropriate remedial actions as needed.

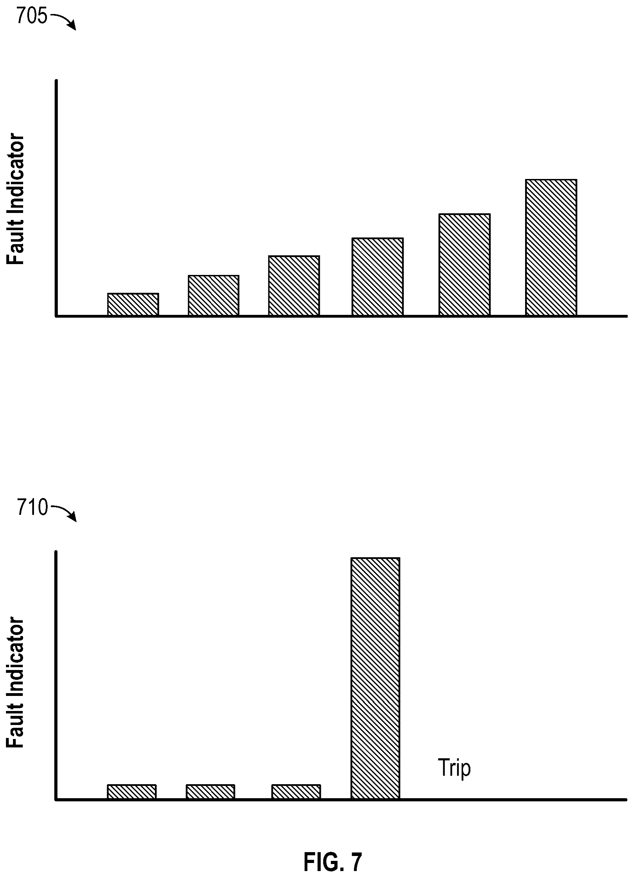

FIG. 7 depicts graphs of fault indication information of an electrical conductor monitoring system in accordance with the present disclosure. By providing the progression of the severity of the detected fault, the electrical insulation monitoring system 300 facilitates the accurate determination of whether warranty services should be applied due to the detected fault. For example, if the changes in the severity of the fault indicate a natural insulation degradation pattern as shown in graph 705, then it can be determined that the fault is covered by the warranty due to the degradation of the insulation. If the changes in the severity of the fault, however, indicate an unnatural insulation degradation pattern (i.e., a sudden surge ) as shown in graph 710, then a further investigation may be performed in order to accurately determine whether the warranty service applies. For example, if the investigation indicates that the detected fault is a result of an accident or oversight by the operator, the warranty does not apply.

Furthermore, implementing the electrical insulation monitoring system 300 is achieved by adding the measurement device 150, 151 at input and output ends 123a, 123b (or upstream and downstream points 231, 232) of the system 120, thereby requiring minimal modification to the equipment of system 120. Moreover, the monitoring system 300 and the method 600 are applicable to any configuration of three-phase systems such as three-phase 3-wire system or three-phase 4-wire system with or without ground, including three-phase systems operating under balanced or unbalanced load(s).

In some embodiments, a differential monitoring method may include the use of differential input and output power or current measurements to identify a faulty phase and/or to estimate fault severity. Such differential values may also be used to estimate a fault current magnitude, for instance, in amperage (e.g., milliampere or mA) and insulation resistance (Rᵢ).

The differential monitoring method may be used for single or multi-phase AC systems, communication systems, and/or DC supply systems, and systems operating using low, medium, or high voltage. In some embodiments, the input signals are AC sinusoidal measurement signals. However, embodiments are not so limited, as various embodiments may operate with other types of signals, such as DC signals, impulse signals, triangular waveform signals, and/or the like with voltage and current flowing through the line. Accordingly, the differential method may be used in electrical distribution systems as well as in communication systems to locate faults or signal leaks (for instance, due to insulation degradation, damage, or leaks).

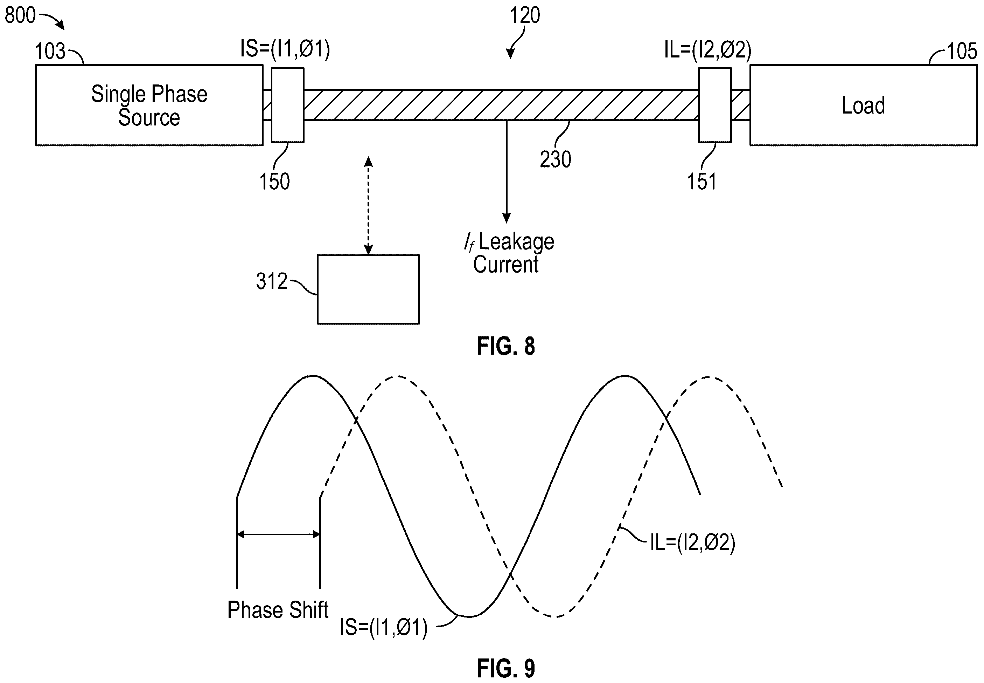

FIG. 8 depicts an illustrative example of an electrical conductor monitoring system in accordance with the present disclosure. As shown in FIG. 8, an electrical conductor monitoring system 800 may include a conduction system 120 (e.g., a busway, cables (with or without trays or other conduit), transmission lines, communication lines, and/or the like) with a measurement section 230 operatively coupled to sensors 150, 151 configured to measure electrical parameters of the measurement section 230. In some embodiments, the conduction system 120 may be a single-phase conduction system. A monitoring device 312 may be communicatively coupled to the sensors 150, 151.

The sensors 150, 151 may be configured to measure electrical parameters of power flowing through the measurement section 230, such as current, voltage, and/or other parameters. The information measured by the sensors 150, 151 may be or may be used to determine IS (source or upstream side) and IL (load or downstream side) as currents in vector form. In some embodiments, IL may include (I1, Ø1) as the magnitude and phase of supply frequency current on the source or upstream side and IS may include (I2, Ø2) as the magnitude and phase of supply frequency current on the load or downstream side.

In some embodiments, a magnitude (D) may be determined by the following: D = I1 - I2. The magnitude may be a peak value obtained through current spectrum at a specified supply frequency (e.g., 50 Hz, 60 Hz, and/or the like). In various embodiments, a phase difference or angle (Ø or ΔØ) may be determined by the following: Ø = Ø1 - Ø2. In various embodiments, the differential method performed by the monitoring system may operate to monitor both magnitude (D) and phase difference (Ø) over time. FIG. 9 depicts an illustrative example of a phase shift or mismatch of currents in vector form. A phase shift or mismatch could occur due to various factors, such as current sensor phase errors, insulation capacitance, a fault, and/or the like.

In some embodiments, faults, such as single phase faults (e.g., line-to-neutral or line-toground) can be detected and monitored using current mismatch approach (ΔD, ΔØ) of the differential method according to various embodiments. In some embodiments, faults, such as DC supply insulation leakage current faults (e.g., line(+) to return(-) or line(+) to ground(0 V)) can be detected and monitored using current mismatch approach (ΔD, ΔØ) of the differential method according to various embodiments.

In some embodiments, the differential method may be performed via executing a software application on the monitoring device. In various embodiments, the differential method may include collecting the instantaneous samples of source (upstream) and load side (downstream) currents, for example, measured via sensors 150, 151. A band pass filter may be applied to focus on the desired frequency of interest, such as a supply frequency (or frequencies) or any other simulated signal (DC/AC). The presence of a phase shift may be determined between two filtered signals (IS and IL). If a phase shift is present, then the shift may be measured and the angle (Ø or ΔØ = Ø1- Ø2) may be recorded. The phase shift may be removed and the two signals may be brought in-phase (i.e., the phase difference is zero or is about zero). A residual signal may be determined by subtracting the two instantaneous signals (with zero phase shift) and the residual magnitude offset between the two signals may be calculated.

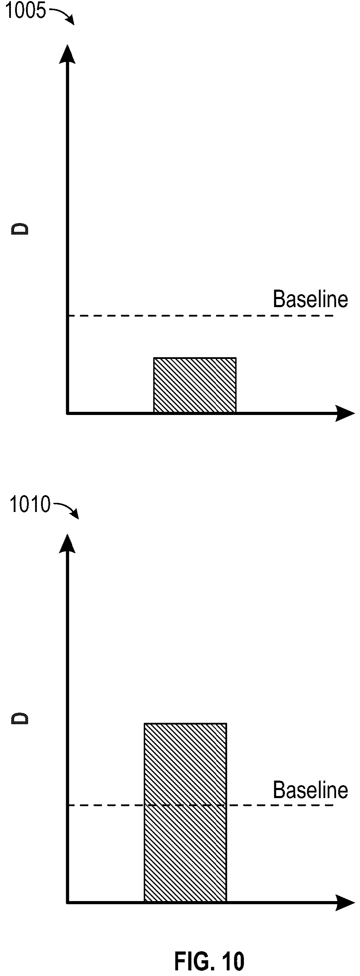

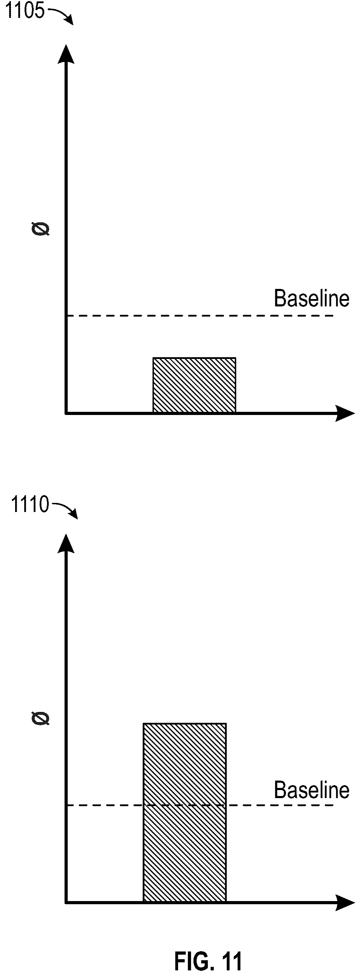

FIG. 10 depicts graphs of monitoring information of a magnitude (D) in accordance with the present disclosure. As shown in FIG. 10, graph 1005 depicts a healthy system with magnitude (D) under a reference baseline and graph 1010 depicts a faulted system with magnitude (D) over a reference baseline. FIG. 11 depicts graphs of monitoring information of a phase difference (Ø) in accordance with the present disclosure. As shown in FIG. 11, graph 1105 depicts a healthy system with a phase difference (Ø) under a reference baseline and graph 1110 depicts a faulted system with a phase difference (Ø) over a reference baseline. For the graphs depicted in FIGS. 10 and 11, monitoring information for a fault indicator may be determined by the following: Fault Indicator = IS - IL = (D, Ø).

The differential method may be used for periodic AC signals, DC signals, communication signals, and/or the like. For example, a frequency spectrum of the residual signal may be determined and a peak value of the desired frequency of interest in the spectrum may be calculated. For a DC signal, the mean or average for the DC signal may be determined in the time domain or peak value at 0 Hz in the frequency spectrum. For non-periodic signals, the greater the fault severity the greater the offset in time domain in D, Ø, or both D and Ø. For periodic signals, the peak value, variance, standard deviation, and/or other statistical parameters for the AC signal or other periodic type signals in time domain or in frequency spectrum may be used.

In some embodiments, for a given line current, a fault current I_{f} may be determined or estimated using the deviation of the current from a respective baseline value (i.e., fault current = baseline - (IS - IL)). Once the leakage fault current (I_{f}) in mA is determined, an estimate of the insulation resistance (Rᵢ) may be determined by the following: Rᵢ = V/I_{f}, where V is the supply voltage value. In some embodiments, the fault current (I_{f}) may be determined by the monitoring system 300 according to the monitoring method and/or via a monitoring system 800 according to the differential monitoring method.

In a healthy system, Rᵢ is in the mega ohm (MΩ) range. However, due to a fault or insulation damage or degradation, the resistance of the insulation may fall into the kΩ, the Ω range, and to about 0 Ω.

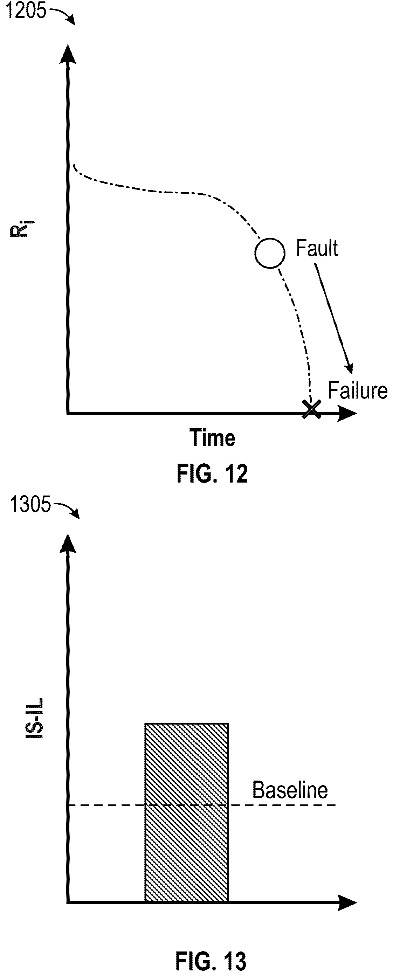

FIG. 12 depicts a graph of monitoring information of Rᵢ over time in accordance with the present disclosure. As shown in graph 1205 of FIG. 12, Rᵢ may decrease over time, for instance, to a fault and/or failure level. FIG. 13 depicts a graph of monitoring information of a fault indicator in accordance with the present disclosure. As shown in graph 1305 of FIG. 13, fault current or fault indicator may be determined corresponding to a baseline - for determining whether the system is healthy or in a fault condition.

Monitoring continuously the value of R (or Rᵢ) using fault current according to the monitoring systems and methods of various embodiments over a period of time may allow the monitoring system to determine a remaining useful life (RUL) of an insulation system and/or a portion of the insulation. For instance, with every increase in temperature of insulation, the life of the insulation reduces by a RUL reduction percentage. In one non-limiting example, a 10 degree C rise in temperature of insulation causes a RUL reduction percentage of about 50%. The rise in temperature may be due to the amount of leakage current. Accordingly, the RUL may be determined based on the leakage current (for instance, based on the resulting rise in temperature in the insulation corresponding to the increase in the leakage current).

In some embodiments, multiple frequencies (for instance, present in the supply voltage spectrum) may be considered in residual current analysis, like harmonics or load frequencies. The supply frequency voltage (for instance, 50 Hz or 60 Hz) will have higher magnitudes, such as 110V, 220V, 440V, etc. As a result, the majority of leakage current will have a 50/60 Hz component. The harmonics of a supply frequency will have a very low magnitude (in the mV or single volt range). Therefore, in the residual time domain current spectrum, the magnitude of these harmonic frequency components may diminish. If the current spectrums of the source and load currents are subtracted, then the resulting difference may be observed only in the line frequency (for example, 50/60 Hz) components and the corresponding harmonics may not experience a difference. Without being bound by theory, the resulting change is due to insulation leakage current only, as it depends on supply voltage and insulation resistance value and not due to interference caused by other conductors nearby. For the same Rᵢ. a low/high voltage leads to a low/high value of the leakage current. The magnitude of each frequency component (for instance, the supply frequency and the supply frequency harmonics and/or other components) in the supply voltage spectrum when divided by the magnitude of same frequency component in residual current spectrum may indicate the value of (Rᵢ), which is essential for monitoring for RUL of conductor insulation.

Accordingly, the monitoring of such patterns according to some embodiments may provide for effective and accurate monitoring of conduction systems and associated components, such as the insulation system.

While specific embodiments have been described in detail, it will be appreciated by those skilled in the art that various modifications and alternatives to those details could be developed in light of the overall teachings of the disclosure. Accordingly, the particular arrangements disclosed are meant to be illustrative only and not limiting as to the scope of disclosed concept which is to be given the full breadth of the claims appended and any and all equivalents thereof.

## Claims

1. An electrical distribution system, comprising: a conduction system formed of at least one segment of multi-phase conductors configured to carry current between a current source and a current load, a measurement system operatively coupled to the multi-phase conductors to measure current information of the multi-phase conductors, the measurement system comprising at least one upstream sensor and at least one downstream sensor arranged at opposite ends of a measurement section of the multi-phase conductors; and a conduction system monitoring device communicatively coupled to the sensor system, the conduction system monitoring device operative to: determine sequence components based on the current information received from the sensor system, determine a sequence component difference based on a comparison of the upstream sequence components at an upstream point of the measurement section with downstream sequence components at a downstream point of the measurement section, the sequence component difference associated with a leakage current of at least one of the multi-phase conductors, and determine a status of the conduction system based on the sequence component difference.

2. The electrical distribution system of claim 1, wherein the multi-phase conductors comprise three-phase conductors.

3. The electrical distribution system of claim 2, the conduction system monitoring device is further operative to determine the sequence component difference as a zero sequence component difference based on a difference between an upstream zero sequence component and a downstream zero sequence component.

4. The electrical distribution system of claim 3, the conduction system monitoring device is further operative to determine a phase-to-phase fault responsive to the zero sequence component difference being greater than a zero sequence threshold.

5. The electrical distribution system of claim 2, the conduction system monitoring device is further operative to determine the sequence component difference as a negative sequence component difference based on a difference between an upstream negative sequence component and a downstream negative sequence component.

6. The electrical distribution system of claim 3, the conduction system monitoring device is further operative to determine a phase-to-ground fault responsive to the negative sequence component difference being greater than a negative sequence threshold.

7. The electrical distribution system of claim 2, wherein the status comprises a status of an insulation system configured to provide insulation between the multi-phase conductors and between the multi-phase conductors and ground.

8. The electrical distribution system of claim 7, the conduction system monitoring device configured to determine a progression of an increase in the sequence component difference.

9. The electrical distribution system of claim 8, the conduction system monitoring device configured to determine whether a fault due to the sequence component difference being over a threshold is due to a degradation of the insulation system.

10. The electrical distribution system of claim 2, the conduction system monitoring device further operative to:
determine a fault status of each phase of the multi-phase conductors, and determine phases of a phase-to-phase fault based on the sequence component difference of each phase of the multi-phase conductors.

11. A method for monitoring insulation health of an insulation system of an electrical distribution system, the method comprising:
providing a measurement system operatively coupled to at least one conductor of a conduction system of the electrical distribution system to measure current information of current flowing from a source to a load through the at least one conductor, the measurement system comprising at least one source side sensor and at least one load side sensor arranged at opposite ends of a measurement section of the at least one conductor; and performing, via an insulation health monitoring system: collecting current information of source side current of the at least one source side
sensor and load side current of the at least one load side sensor, determining a source side
current vector (IS) and a load side current vector (IL)
based on the current information, determining a fault current (I_{f}) based on a difference
between IS and IR, and estimating an insulation resistance (Rᵢ) based on I_{f},

12. The method of claim 11, further comprising, via the insulation health monitoring system, determining a remaining useful life (RUL) of at least one component of the insulation system based on Rᵢ.

13. The method of claim 11, further comprising, via the insulation health monitoring system, determining Rᵢ based on Rᵢ = V/I_{f}, wherein V is a supply voltage value.

14. The method of claim 11, wherein the source side current vector (IS) comprises a magnitude (I1) and an angle (Ø1) of the source side current and the load side current vector (IS) comprises a magnitude (I2) and an angle (Ø2) of the load side current.

15. The method of claim 11, further comprising, via the insulation health monitoring system, applying a filter to use current information of a supply frequency of interest.
